# EUROPEAN PATENT APPLICATION

(11) **EP 3 404 775 A1**
(43) Date of publication of application: **21.11.2018**
(21) Application number: 17172051.9
(22) Date of filing: 19.05.2017
(51) Int. Cl.: H01R 13/629, H01R 13/518, H05K 7/14, H01R 9/26

(54) **MODULE ASSEMBLY WITH A COMBINED DRIVING AND LOCKING MECHANISM**

(71) Applicant: TYCO ELECTRONICS (UK) LTD, Swindon, Wiltshire SN3 5HH (GB)
(72) Inventor: Eyles, Johnathan Mark, Swindon, Wiltshire SN3 5BW (GB); Kopinski, Tomasz, Swindon, Wiltshire SN3 1QA (GB); MacNaughton, Roy, Swindon, Wiltshire SN1 4LT (GB); Brownjohn, Nicholas, 21614 Buxtehude (DE); Osternack, Stefan, 22587 Hamburg (DE)
(74) Representative: Grünecker Patent- und Rechtsanwälte PartG mbB

(57) **Abstract**

The invention relates to a module assembly (11) for a plug-in module (5) or a connector (3). In order to provide a module assembly (11) which is capable of assisting the connection process with a counterpart such as a rack, and, at the same time, offers a solution which helps to maintain a connection of a plug-in module or a connector with its counterpart, the invention provides a module assembly (11), the assembly (11) comprising at least one combined driving and locking mechanism (19) with a first lever (27) and a second lever (29), each lever (27, 29) being supported rotatably around a rotary axis (31, 33), the rotary axes (31, 33) of the levers (27, 29) being spaced apart from each other in a horizontal direction (H), wherein the module assembly (11) comprises a coupling arrangement (43) mechanically coupling the rotational movements of the two levers (27, 29) with each other, wherein each lever (27, 29) is provided with at least one driving member (59, 61) which is rotatable with its corresponding lever (27, 29) around the lever's rotary axis (31, 33), and wherein the combined driving and locking mechanism (19) is movable between an insertion position (23) and a locking position (25), wherein an angle (α) between both levers (27, 29) is smaller in the insertion position (23) than in the locking position (25) and wherein the levers (27, 29) are latched with each other in the locking position (25).

## Description

The invention relates to a module assembly for a plug-in module or a connector. The invention further relates to a connector system which comprises at least one connector and at least one mating connector for being connected to the connector.

Module assemblies and connector systems are known in the field of electrical and/or optical connections. Module assemblies may for example be part of a plug-in module such as a cartridge which is insertable into a rack. Another example for the application of a module assembly is a connector which is adapted for being connected to a mating connector. A plug-in module or a connector of the above-mentioned types are generally provided with at least one electrical and/or optical contact which is to be connected with a corresponding mating contact in a counterpart, such as the aforementioned racks or mating connectors. In some cases, it may be desirable to assist an operator during the connection process. This may be the case if strong forces need to be overcome in order to connect the module or the connector with its counterpart, or if a high precision with respect to the positions of contacts in the module assembly and the corresponding contacts in the counterpart is needed. In certain circumstances, it may be required to secure the position of the module assembly after connecting the plug-in module or the connector with its counterpart. This may be, for example, the case in environments in which vibrations occur such as in planes or vehicles.

It is therefore the object of the invention to provide a module assembly and a connector system as described above, which are capable of assisting the connection process and, at the same time, offer a solution which helps to maintain a connection of a plug-in module or a connector with its counterpart.

This object is solved for the module assembly as described above in that the assembly comprises at least one combined driving and locking mechanism with a first lever and a second lever, each lever being supported rotatably around a rotary axis, the rotary axes of the levers being spaced apart from each other in a horizontal direction, wherein the module assembly comprises a coupling arrangement mechanically coupling the rotational movements of the two levers with each other, wherein each lever is provided with at least one driving member which is rotatable with its corresponding lever around the lever's rotary axis, and wherein the combined driving and locking mechanism is movable between an insertion position and a locking position, wherein an angle between both levers is smaller in the insertion position than in the locking position and wherein the levers are latched with each other in the locking position.

For the connector system according to the invention, the object is solved in that the at least one connector has at least one module assembly according to the invention and in that the mating connector comprises at least two engagement members for receiving the at least two driving members of the at least one module assembly.

The combined driving and locking mechanism may assist in connecting a plug-in module or a connector with a counterpart. The driving members of the levers may interact with complementary engagement members on a counterpart such that the driving members move the module or the connector towards and/or into its counterpart during rotation of the levers from the insertion position towards the locking position.

For example, a plug-in module such as a cartridge may be inserted into a rack. Thereby, during insertion of the cartridge into the rack, the driving members can interact with the engagement members of the rack such that a lever rotation is converted into a driving force that drives the cartridge into the rack. In the locking position, the driving members may stay engaged with the engagement members of the rack such that the cartridge cannot be removed from the rack without first moving the levers back from the locking position into the insertion position. It should be noted that in the locking position, electrical and/or optical contacts of the cartridge may be fully connected to complementary contacts of the rack. The same applies in the case that the module assembly is used for a connector and mating connector instead of a plug-in module such as a cartridge.

In the locking position, the levers are latched with each other such that they cannot be rotated back into the insertion position without first disengaging the levers from each other. Thereby, the locking position is preserved and the connection of the module with the rack is secured.

Finally, since the assembly comprises two levers which are mechanically coupled with each other, the plug-in module or the connector can be smoothly inserted into the mating counterpart without the risk of being tilted during insertion. The smooth insertion process is facilitated by the two levers which each drive at least one driving member which, in turn, move symmetrically with each other during movement of the levers as a consequence of the mechanical coupling. The movement of the driving members is in particular symmetrical with respect to a mirror plane of symmetry which extends perpendicular to the horizontal direction. In other words, both levers can rotate about an equal angle, around their respective rotary axes, wherein the directions of rotation of the levers are opposite to each other.

It should be noted that the term "horizontal direction" refers to a direction of the assembly itself and not to a direction with respect to an outer coordinate system.

In the following, further improvements of the invention are described. The additional improvements may be combined independently of each other, depending on whether a particular advantage of a particular improvement is needed in a specific application.

The assembly may comprise a module frame for carrying at least one electric and/or optical contact. The levers may be mounted rotatably on the module frame.

In order to provide a reliable coupling of the levers, the at least one coupling arrangement may be provided with at least one cam track on at least one of the levers and at least one pin on the other lever, wherein the at least one pin is slidable arranged in the at least one cam track. The at least one cam track may have an end position for the insertion position and another end position for the locking position.

In order to equally distribute forces from one lever to the other lever, the cam track is preferably spaced apart from its lever's rotary axis. In particular, the cam track may extend across a mid-section of the combined driving and locking mechanism in the horizontal direction.

The first lever may be provided with at least one latching member and the second lever may be provided with at least one complementary latching member, the latching members being engaged with each other in the locking position. This may provide a secure latching of the levers with each other. The latching members may in particular be formed as latching hooks.

In order to facilitate the latching of the levers with each other, the at least one latching member may be supported slidably on the first lever along a longitudinal direction of the lever, the longitudinal direction of the lever being perpendicular to the rotary axis of the lever.

A slidability of the at least one latching member can easily be achieved in that the first lever comprises at least one actuating part and at least one supporting part, wherein the at least one supporting part is supported rotatably around the first lever's rotary axis, and wherein the at least one actuating part is provided with the at least one latching member and is held slidably on the at least one supporting part perpendicular to the rotary axis of the first lever. In particular, the actuating part may be captively connected to the at least one supporting part. The supporting part is preferably captively connected to the module frame. The slidability refers to the ability for performing a translational movement perpendicular to rotary axis. Preferably, the actuating part is adapted for being actuated by an operator.

In order to further improve the reliability of the latching of the levers, a spring is preferably provided between the at least one actuating part and the at least one supporting part, the spring urging apart the at least one actuating part and the at least one supporting part in a direction perpendicular to the rotary axis of the first lever. The spring may, just by way of example, be a helical coil spring. The spring force preferably acts in a direction in which the at least one latching member and the at least one complementary latching member are engageable with each other.

If the coupling arrangement is provided with at least one cam track, then this at least one cam track is preferably adapted for allowing a translational movement of the levers relatively to each other along the horizontal direction, at least in the locking position. This may allow the sliding movement of the at least one latching member.

In particular, the at least one cam track may be provided with a space for horizontal movement of the pin in the end position which corresponds to the locking position. Said space may for example be either formed by a horizontal branch of the cam track or by a broadened region of the cam track.

The second lever is preferably provided with at least one secondary locking means which, in a blocking position of the secondary locking means, blocks the disengagement of the levers from each other. Said secondary locking means may secure the positions of the levers relatively to each other in the locking position.

Preferably, the secondary locking means is elastically deflectable out of the blocking position in order to allow the disengagement of the levers, when needed.

The at least one secondary locking means may be seated on a leaf spring, wherein the secondary locking means is arranged in the blocking position when the leaf spring is in a resting position. By this arrangement, the elastic deflectability can easily be achieved. Preferably, the leaf spring basically extends along the longitudinal direction of the second lever and is fixated to the second lever with an end opposite to the free end of the leaf spring.

In order to further improve the blocking of the disengagement of the levers by the secondary locking means, the at least one secondary locking means is preferably arranged on a free end of the leaf spring, wherein, in the blocking position, the at least one secondary locking means is arranged between an abutment portion of the actuating part of the first lever and a counter abutment portion of the second lever, blocking the movement of the actuating part perpendicular to the rotational axis of the first lever.

In the case the disengagement of the levers desired, the first lever may be provided with at least one release member with which the at least one secondary locking means is movable from the blocking position into a releasing position.

Preferably, the at least one release member is formed as a pushing portion of the actuating part which is elastically deflectable towards the at least one secondary locking means in the locking position.

In order to further improve the securing of the levers in the locking position, the at least one actuating part may be provided with at least one insertion channel and the at least one supporting part is provided with at least one through hole, wherein the at least one insertion channel and the at least one through hole are aligned with each other parallel to the rotary axis of the first lever at least when the levers are latched with each other. When the insertion channel and the at least one through hole are aligned with each other, an external locking member such as a cable tie may be guided through the through hole and the insertion opening such that a sliding movement of the actuating part relatively to the supporting part is prevented. In the alternative, the at least one insertion channel may be provided on the supporting part and the at least one through hole may be arranged on the actuating part.

For an additional improvement, the at least two driving members may be shaped such that insertion faces of the driving members are aligned parallel with an insertion direction of the module assembly in the insertion position. The insertion faces are preferably formed by outer edges extending away from the assembly along the horizontal direction. The alignment parallel with the insertion direction may aid a smooth insertion of the module into a counterpart such as a rack.

Each lever may further be provided with at least one pushing member which, at least in the insertion position, projects from the remaining module frame along the horizontal direction on two opposing sides of the module frame. The pushing members may encounter a counterpart such as a rack during insertion of the module and, thereby induce the rotational movement of the levers.

In the following, the invention and its improvements are described in greater detail using an exemplary embodiment and with reference to the figures. As described above, the various features shown in the embodiment may be used independently of each other in specific applications.

In the following figures, elements having the same function and/or the same structure will be referenced by the same reference signs.

In the drawings:
- Fig. 1: shows a preferred embodiment of a connector assembly according to the invention with a module assembly according to the invention in a schematic view;
- Figs. 2a to Fig. 2c: show the insertion and locking sequence of the connector assembly;
- Fig. 3: shows a cut view of the combined driving and locking mechanism in the insertion position;
- Fig. 4: shows the same view as Fig. 5 with the levers being partially rotated;
- Fig. 5: shows the levers of Fig. 3 and Fig. 4 in the locking position;
- Fig. 6: shows a schematic cut out view of the levers latching members prior to being latched;
- Fig. 7: shows the latching members of Fig. 6 in a latched position;
- Fig. 8: shows a close up schematic view of the first lever comprising aligned through holes positioned to accept an external locking member such as a cable tie; and
- Fig. 9: shows an exploded view of the combined driving and locking mechanism.

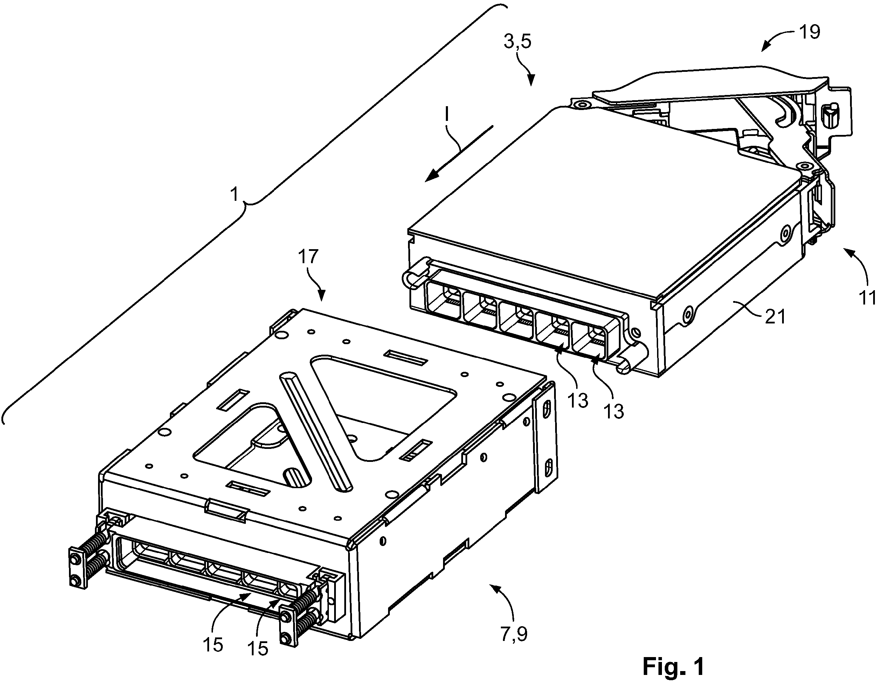

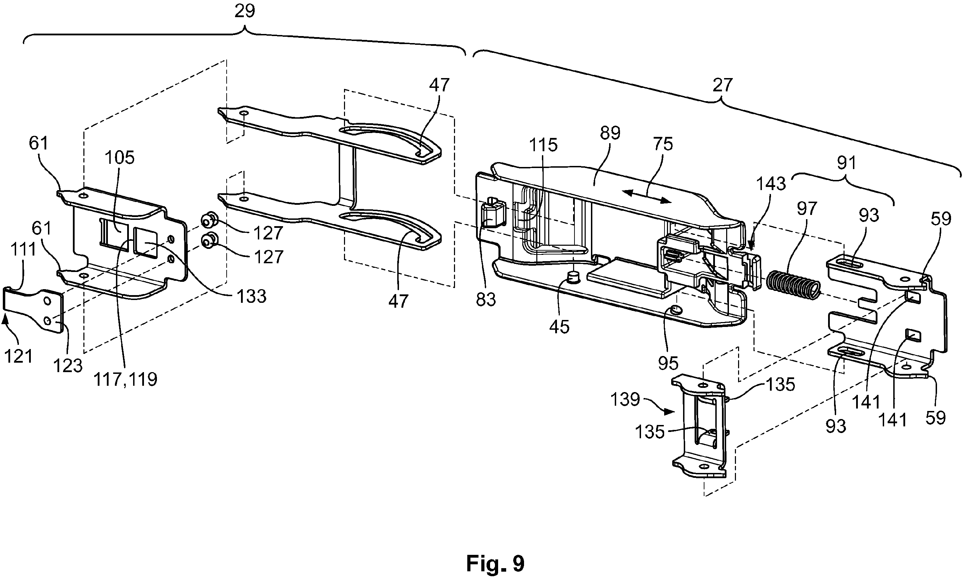

In the following, a preferred embodiment of the invention is described with respect to Figs. 1 to 8. For a better understanding of the invention, reference is also made to Fig. 9, in which parts of the combined driving and locking mechanism are shown in an exploded view.

In Fig. 1, a connector system 1 according to the invention is shown. The system 1 comprises a connector 3 which is, just by way of example, a cartridge 5, and a mating connector 7 which is, just by way of example, a rack 9.

The cartridge 5 is provided with a module assembly 11 according to the invention.

The cartridge 5 is provided with contacts 13 which may be electrical and/or optical contacts. The rack 9 is provided with mating contacts 15 which are complementary to the contacts 13 such that each contact 13 can be connected to a corresponding mating contact 15. For connecting the contacts 13 with the mating contacts 15, the cartridge 5 is insertable into a receptacle 17 of the rack 9. Preferably, the cartridge 5 is insertable along an insertion direction I into the rack 9.

The module assembly 11 comprises a combined driving and locking mechanism 19 and, preferably, also a module frame 21 to which the combined driving and locking mechanism 19 is captively connected. The module frame 21 is formed such that it is insertable into the receptacle 17 of the rack 9.

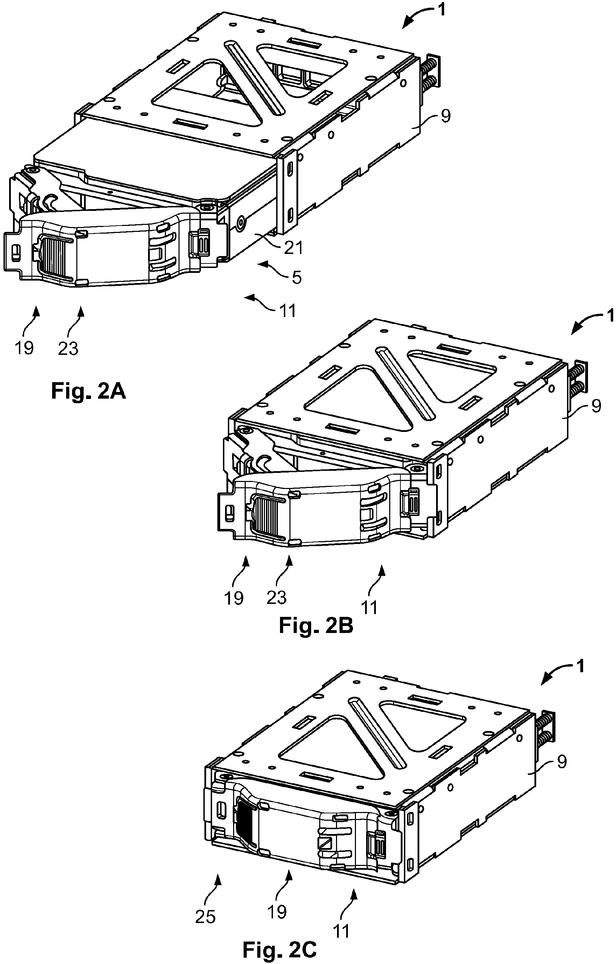

In the following, the insertion of the cartridge 5 into the rack 9 and further features of the connector system 1 are described in greater detail referring to Figs. 2a to 2c. Thereby, Fig. 2a shows the system 1 in a position in which the cartridge 5 is partially inserted in the receptacle 17. Fig. 2b shows the cartridge 5 being further inserted into the rack 9 prior to using the mechanism 19 and Fig. 2c shows the system 1 with the cartridge 5 being fully inserted into the receptacle 17 of the rack 9.

In Figs. 2a and 2b, the combined driving and locking mechanism 19 is in an insertion position 23 in which the cartridge 5 is insertable and extractable from the rack 9. Thereby, Fig. 2b shows the assembly 11 with the mechanism 19 still in the insertion position 23 prior to using the mechanism 19 for further inserting the cartridge 5 into the rack 9 and prior to locking the cartridge 5 in the rack 9 using the mechanism 19.

Fig. 2c shows the mechanism 19 in a locking position 25. In the locking position 25, the cartridge 5 cannot be extracted from the rack 9 without first moving the mechanism 19 into the insertion position 23. Moreover, if the cartridge 5 is fully inserted in the rack 9 and the mechanism 19 is in the locking position 25, the contacts 13 and the mating contacts 15 (not shown in Figs. 2a to 2c) are contacted with each other.

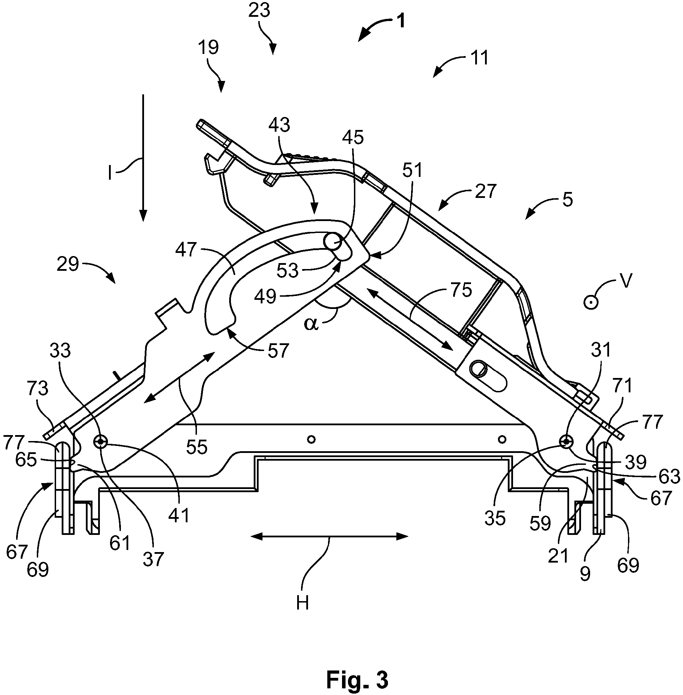

In the following, the module assembly 11 and the connector system 1 are described in greater detail with reference to Fig. 3. Fig. 3 shows the cartridge 5 partially inserted into the rack 9 and resembles the situation as already described with respect to Fig. 2b.

The combined driving and locking mechanism 19, in the following mechanism 19, comprises a first lever 27 and second lever 29. The first lever 27 is supported rotatably around a first rotary axis 31, and the second lever 29 is supported rotatably around a second rotary axis 33.

In the regions of the axes 31 and 33, the levers 27 and 29 are captively connected to the module frame21. By way of example, the embodiment of the module assembly 11 is shown with pins 35 and 37 on the module frame 21, which protrude into openings 39 and 41 in the levers such that the levers are captively connected and rotatable around the axes 31 and 33. The positions of the pins 35 and 37 and the centers of the openings 39 and 41 are aligned with the rotary axes 31 and 33.

In the alternative, this arrangement may also be the other way around. For example, the levers 27 and 29 could be provided with pins that protrude into openings in the module frame 21. Instead of pins, the assembly may also be provided with axles or other features that allow the levers 27 and 29 being rotatably supported on the module frame 21.

The axes 31 and 33 are spaced apart from each other in a horizontal direction H. The horizontal direction H is preferably perpendicular to the aforementioned insertion direction I. The axes 31 and 33 are preferably arranged at the same height seen in the insertion direction I. The axes 31 and 33 extend parallel with a vertical direction V of the assembly 11. The vertical direction V is perpendicular to the horizontal direction H and the insertion direction I.

The levers 27 and 29 are mechanically coupled by a coupling arrangement 43. The coupling arrangement 43 couples the rotational movement of both levers 27 and 29. The coupling arrangement 43 is formed by two pins 45 on the first lever 27 and two corresponding cam tracks 47 on the second lever 29. The two pins 45 are spaced apart from each other in the vertical direction V. Consequently, the two corresponding cam tracks 47 are also spaced apart from each other in the vertical direction V.

For the sake of clarity, the setup and the function of the coupling arrangement 43 is described with respect to a single cam track 47 and its corresponding pin 45 only. The cam track 47 is formed such that the rotational movement of the first lever 27 is transmitted to the second lever 29 in a way that both levers 27 and 29 rotate about an equal angle around their respective rotary axes 31 and 33. The angles are equal with respect to their absolute values, whereas the rotational direction of both levers 27 and 29 are contrary to each other.

During the rotation of the levers 27 and 29 from the insertion position 23 towards the locking position 25, both levers 27 and 29 move towards the module frame 21. Thereby, an angle α between both levers 27 and 29 increases.

The cam track 47 is basically arranged in a second half of the second lever 29 which comprises the free end 51 of the second lever 29 and which is spaced apart from the rotary axis 33. The cam track 47 has a first end position 49 which is arranged close to the free end 51 of the second lever 29.

If the pin 45 is arranged in the first end position 49, a movement of the levers 27 and 29 from the insertion position 23 to the locking position 25 is prevented by an abutment surface 53 which basically extends horizontally to a longitudinal direction 55 of the second lever 29. The pin 45 abuts the abutment surface 53 and, if a force in the insertion direction I is exerted on the first lever 27, the pin 45 is pressed into the first end position 49 and against the abutment surface 53 such that an unintended rotation of the levers 27 and 29 is prevented.

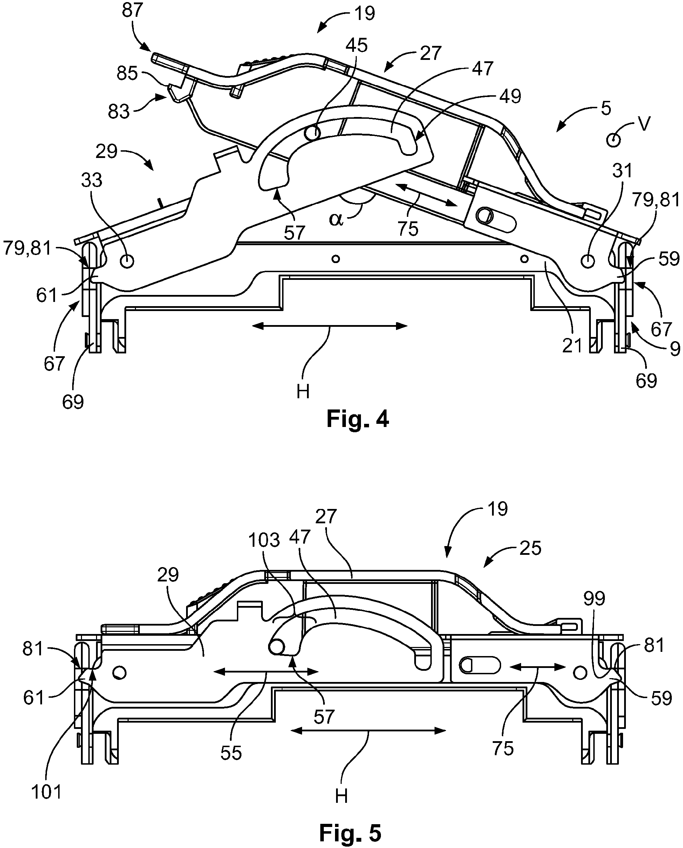

The cam track 47 further has a second end position 57 which refers to the locking position 25 of the mechanism 19. The second end position 57 is arranged at the opposite end of the cam track 47 seen from the first end position 49. Consequently, the second end position 57 is arranged between the free end 51 and the rotary axis 33 of the second lever 29. The second end position 57 of the cam track 47 and the locking position 25 of the mechanism 19 are described in greater detail later on with respect to Fig. 5.

The first lever 27 is provided with two driving members 59 which are spaced apart from each other in the vertical direction V. The second lever 29 is provided with two driving members 61 which are also spaced apart from each other in the vertical direction V. As for the coupling arrangement 43, the driving members 59 and 61 are described with respect to a single driving member on each lever for the sake of clarity.

The driving members 59 and 61 of the levers 27 and 29 are arranged symmetrically to each other with respect to a mirror plane of symmetry which extends perpendicular to the horizontal direction H. Further, due to the mechanical coupling between the levers 27 and 29, the driving members 59 and 61 move symmetrically with respect to said mirror plane of symmetry.

The driving member 59 of the first lever 27 extends away from the rotary axis 31 opposite to the part of the lever 27 that is provided with the pin 45. Likewise, the driving member 61 of the second lever 29 extends away from the second rotary axis 33 opposite to the part of the lever 29 which is provided with the cam track 47. Consequently, the rotary axis 33 is arranged between the driving member 61 and the part of the second lever 29 which is provided with the cam track 47.

Both driving members 59 and 61 comprise an insertion face 63 and 65. The insertion faces 63 and 65 are the outermost parts of the driving members 59 and 61 seen in the horizontal direction H. In other words, the insertion faces 63 and 65 form outer edges of the driving members 59 and 61.

The insertion faces 63 and 65 are arranged parallel with the insertion direction I when the levers 27 and 29 are rotated away from the module frame 21 or, in other words, the mechanism 19 is in the insertion position 23. The insertion faces 63 and 65, being aligned parallel with the insertion direction I, facilitate the insertion of the cartridge 5 into the rack 9.

The rack 9 is provided with openings 67 in outer walls 69 of the rack 9. The driving members 59 and 61 can be received in the openings 67. This is described later on in greater detail with respect to Figs. 4 and 5.

Each lever 27 and 29 is further provided with a pushing member 71 and 73. The pushing members 71 and 73 of the two levers 27 and 29 are, as the driving members 59 and 61, arranged symmetrically with each other. The pushing members 71 and 73 extend in the shape of a plane away from each lever 27 and 29 opposite to each other.

The pushing member 71 of the first lever 27 extends basically parallel with a longitudinal direction 75 of the first lever 27 and parallel with the rotary axis 31. Likewise, the pushing member 73 of the second lever 29 extends parallel with the longitudinal direction 55 of the second lever 29 and the second rotary axis 33. In a direction against the insertion direction I, the pushing members 71 and 73 are arranged atop the driving members 59 and 61. Thereby, the pushing members 71 and 73 are spaced apart from the corresponding driving members 59 and 61 in a direction perpendicular to the longitudinal direction and the rotary axis of each lever 27 and 29.

The rack 9 is provided with pushing edges 77 which are formed on walls 69 of the rack 9. The pushing edges 77 are arranged opposite to each other in the horizontal direction H. The pushing edges 77 are, seen along the horizontal direction H, arranged basically at the same height as the pushing members 71 and 73. Further, the pushing edges 77 are arranged and shaped such that the pushing members 71 and 73 may encounter the pushing edges 77 during insertion of the cartridge 5 into the rack 9. The pushing edges 77 are arranged atop the openings 67 in a direction against the insertion direction I. In other words, the walls 69 of the rack 9 form the pushing edges 77 with their ends that point against the insertion direction I. Said walls 69 also comprise the openings 67 which are arranged below the pushing edges 77 in the insertion direction I.

If, starting at the position as described with respect to Fig. 3, the cartridge 5 is further moved into the rack 9, the pushing members 71 and 73 encounter the pushing edges 77 of the rack 9. Further movement of the cartridge 5 along the insertion direction I will result in a rotational movement of each lever 27 and 29 due to the force that is exceeded by the pushing edges 77 on the pushing members 71 and 73. This movement will rotate both levers 27 and 29 such that the pin 45 of the coupling arrangement 43 leaves the first end position 49. Consequently, the pin 45 may now be guided along the cam track 47 towards the second end position 57 when a pushing force is exceeded on the first lever 27 in the insertion direction I. This situation is shown in Fig. 4.

In Fig. 4, an intermediate state between the insertion position 23 and the locking position 25 is shown. The levers 27 and 29 have moved further towards the module frame 21 such that the angle α between both levers 27 and 29 is larger than in the insertion position 23. In this situation, the pin 45 has moved about half of the cam track 47 from the first end position 49 towards the second end position 57.

Due to the rotation of the levers 27 and 29 around their rotary axes 31 and 33, the driving members 59 and 61 have been moved apart from each other in the horizontal direction H and now extend into the openings 67 in the walls 69 of the rack 9. The wall sections 79 of the walls 69 which are arranged between the openings 67 and the pushing edges 77 act as engagement members 81 for the driving members 59 and 61. During rotation of the levers 27 and 29 towards the locking position 25, the driving members 59 and 61 push against the engagement members 81 and drive the cartridge 5 into the rack 9. As a consequence, the contacts 13 are contacted with the mating contacts 15.

The first lever 27 is provided with a latching member 83 for being engaged with a complementary latching member (not shown yet) of the second lever 29. The latching member 83 is shaped as a latching hook which extends from the remaining lever 27 towards the module frame 21 with a latching lug 85 pointing in the direction of a free end 87 of the lever 27.

The latching member 83 is arranged on an actuating part 89 of the first lever 27 which is held slidably on a supporting part 91 of the lever 27. The supporting part 91 is the part which is captively connected to the module frame 21 at the first rotary axis 31. The actuating part 89 may be used for actuating the first lever 27 and thereby for actuating the mechanism 19. The actuating part 89 is held slidably along the longitudinal direction 75 of the first lever 27. As a consequence, the latching member 83 is supported slidably on the first lever 27 along the same direction. Thereby, engaging the latching member 83 with a complementary latching member of the second lever 29 and also the disengagement of the latching members may be facilitated.

In order to allow the sliding movement of the actuating part 89 with respect to the supporting part 91, the supporting part 91 is provided with a pair of cam tracks 93 which basically extend parallel with the longitudinal direction 75 of the lever 27. The actuating part 89 is provided with a pair of corresponding pins 95 which are slidably arranged in the cam tracks 93. Both cam tracks 93 and both pins 95 are aligned with each other in the vertical direction V and are spaced apart from each other in the same direction.

The actuating part 89 and the supporting part 91 are urged apart from each other by a spring 97 (shown in Fig. 9) which is arranged between both parts. Consequently, the spring 97 exerts a force on the actuating part 89 in the direction of the latching lug 85 and therefore helps in keeping the latching member 83 in engagement with the latching member of the second lever 29.

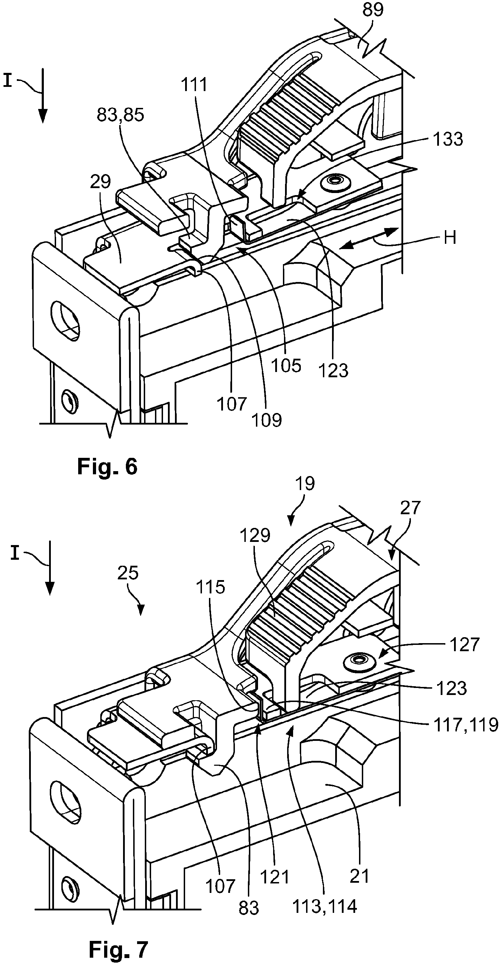

Reference is now made to Fig. 5 which shows the mechanism 19 in the locking position 25. The engagement between the levers 27 and 29 will be described later on with respect to Figs. 6 and 7. The longitudinal directions 55 and 75 of both levers 27 and 29 are now parallel with each other and parallel with the horizontal direction H. Consequently, the angle α (not shown) is now 180°. The driving members 59 and 61 are fully inserted in the openings 67 and abut the engagement members 81 with abutment surfaces 99 and 101. The abutment surfaces 99 and 101 are parallel with the horizontal direction H in the locking position 25.

The cam track 47 has a broadened region 103 at its second end position 57 which allows a translational movement of the pin 45 parallel with the horizontal direction H. Consequently, at least the actuating part 89 of the first lever 27 is movable relatively to the second lever 29. As an alternative to the broadened region 103, the cam track 47 may also be provided with a branch that extends basically parallel with the horizontal direction H.

In the following, the latching of the levers 27 and 29 with each other is described with respect to Figs. 6 and 7 which show a cutout view of the region around the latching member 83. Thereby, Fig. 6 shows the latching member 83 approaching the complementary latching member of the second lever 29 prior to engagement. Fig. 7 shows both levers 27 and 29 in a fully engaged state.

As already described above, the first lever 27 is provided with an engagement member 83 that is formed as a latching hook with a latching lug 85 which basically extends in the direction of the free end 87 and, consequently, towards the rotary axis 33 of the second lever 27.

The second lever 29 is provided with an insertion opening 105 for receiving the latching member 83. The insertion opening 105 is closed at one side by the complementary latching member 107 of the second lever 29. The complementary latching member 107 is shaped complementary to the latching member 83 of the first lever 27.

The complementary latching member 107 is formed as a latching hook which basically extends from the second lever 29 towards the module frame 21. The complementary latching member 107 is arranged such that it closes the insertion opening 105 in a direction towards the second rotary axis 33. In the locking position 25 as shown in Fig. 7, the latching member 83 is arranged below the complementary latching member 107 or, in other words, follows the complementary latching member 107 in the insertion direction I.

Starting at the position shown in Fig. 6, the levers 27 and 29 may be latched to each other by pushing on the actuating part 89. Due to the ability of the actuating part 89 to slide along the horizontal direction H, the latching member 83, which is provided with an inclined surface 109, may slide along the complementary latching member 107 into the insertion opening 105. Thereby, the latching member 83 moves along the horizontal direction H towards the first rotary axis 31 and, at the same time, along the insertion direction I towards the module frame 21.

When the latching member 83 is arranged in the insertion opening 105, the spring force exerted by the spring 97 pushes the latching member 83 against the complementary latching member 107. The mechanism 19 is then in the locking position 25.

The second lever 29 is provided with a secondary locking means 111. The secondary locking means 111 blocks the disengagement of the levers 27 and 29 from each other when it is arranged in a blocking position 113. In particular, the secondary locking means 111 blocks the sliding movement of the actuating part 89 towards the supporting part 91. As a consequence, the latching member 83 can not be removed from the complementary latching member 107.

When the levers 27 and 29 are in the locking position 25 and when the secondary locking means 111 is in the blocking position 113, the secondary locking means 111 is arranged between an abutment portion 115 of the actuating part 89 and a counter abutment portion 117 en the second lever.

The abutment portion 115 is spaced apart from the latching member 83 along the horizontal direction H and is situated closer to the first rotary axis 31 than the latching member 83. The counter abutment portion 117 is formed as a web 119 which closes the insertion opening 105 in the direction towards the free end 51 of the second lever 29.

The secondary locking means 111 is elastically deflectable out of the blocking position 113. Removal of the secondary locking means 111 from its position between the abutment portion 115 and the counter abutment portion 117 unblocks the actuating part 89 such that it is movable towards the supporting part 91 again.

In particular, the secondary locking means 111 is elastically deflectable in the insertion direction I towards the module frame 21. In order to be elastically deflectable, the secondary locking means 111 is seated on a free end 121 of a leaf spring 123. The leaf spring 123 basically extends parallel with the longitudinal direction 55 of the second lever 29. In a resting position 124 of the leaf spring 123, the secondary locking means 111 is in its blocking position 113.

Opposite to the free end 121, the leaf spring 123 has a fixed end 125. Preferably, the leaf spring 123 is fixated to the remaining second lever 29 by riveting. More preferably, the leaf spring 123 is connected to the remaining second lever 29 by two rivet joints 127.

In order to easily move the secondary locking means 111 from the blocking position 113 towards a releasing position (not shown), the first lever 27 is provided with a release member 129. The release member 129 is formed as a pushing portion 131 of the actuating part 89. The release member 129 is elastically deflectable towards the secondary locking means 111 in the locking position 25.

The second lever 29 is provided with a through hole 133 through which the release member 129 can be pushed against the leaf spring 123 in order to elastically deflect the leaf spring 123 such that the secondary locking means 111 is moved out of its blocking position 113. The through hole 133 is arranged behind the insertion opening 105 in a direction towards the free end 51 of the second lever 29. The insertion opening 105 and the through hole 133 are divided by the web 119 which extends parallel with the second rotary axis 33.

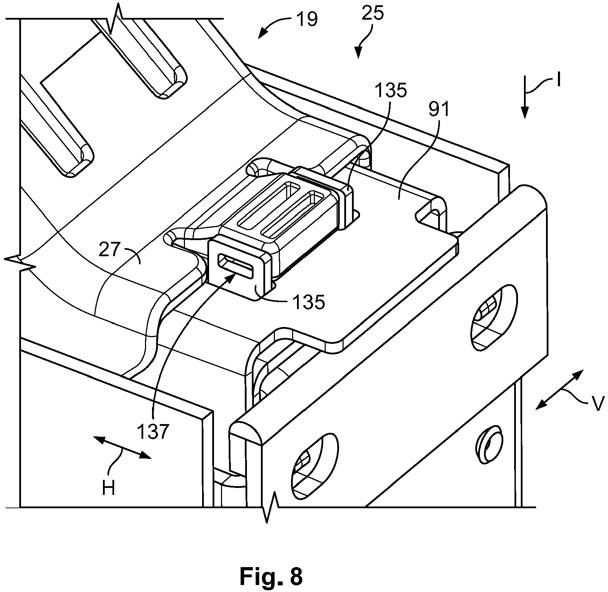

In Fig. 8, another feature for securing the locking position 25 of the mechanism 19 is shown. The supporting part 91 of the first lever 27 is provided with two plates 135 which are spaced apart from each other in the vertical direction V and which extend parallel with the horizontal direction H and the insertion direction I. Each plate 135 is provided with a through hole 137.

The plates 135 are preferably arranged on a separate part 139 which can be combined with the remaining supporting part 91 of the first lever 27 (see Fig. 9). In particular, the remaining supporting part 91 may be provided with two openings 141 through which the plates 135 can protrude against the insertion direction I.

The actuating part 89 is provided with an insertion channel 143 which extends parallel with the vertical direction V and which is closed against the insertion direction I. In the locking position 25, the through holes 137 and the insertion channel 143 are aligned with each other in the vertical direction V.

In order to further secure the locking position 25, a separate part, such as a cable tie (not shown) may be inserted through the through holes 137 and through the insertion channel 143. This secures the relative position of the actuating part 89 and the supporting part 91. An inserted and fixated separate part, such as a cable tie, may further indicate that the installation process of the cartridge 5 into the rack 9 is fully accomplished.

### REFERENCE NUMERALS

- 1: connector system
- 3: connector
- 5: cartridge
- 7: mating connector
- 9: rack
- 11: module assembly
- 13: contact
- 15: mating contact
- 17: receptacle
- 19: driving and locking mechanism
- 21: module frame
- 23: insertion position
- 25: locking position
- 27: first lever
- 29: second lever
- 31: first rotary axis
- 33: second rotary axis
- 35: pin
- 37: pin
- 39: opening
- 41: opening
- 43: coupling arrangement
- 45: pin
- 47: cam tack
- 49: first end position
- 51: free end
- 53: abutment surface
- 55: longitudinal direction of the second lever
- 57: second end position
- 59: driving member
- 61: driving member
- 63: insertion face
- 65: insertion face
- 67: openings
- 69: wall of the rack
- 71: pushing member
- 73: pushing member
- 75: longitudinal direction of the first lever
- 77: pushing edges
- 79: wall sections
- 81: engagement members
- 83: latching member
- 85: latching lug
- 87: free end of the first lever
- 89: actuating part
- 91: supporting part
- 93: cam track
- 95: pins
- 97: spring
- 99: abutment surface
- 101: abutment surface
- 103: broadened region
- 105: insertion opening
- 107: complementary latching member
- 109: inclined surface
- 111: secondary locking means
- 113: blocking position
- 115: abutment portion
- 117: counter abutment portion
- 119: web
- 121: free end of the leaf spring
- 123: leaf spring
- 124: resting position of the leaf spring
- 125: fixed end
- 127: rivet joined
- 129: release member
- 131: pushing portion
- 133: through hole
- 135: plates
- 137: through holes in the plates
- 139: separate part
- 141: opening
- 143: insertion channel

- H: horizontal direction
- I: insertion direction
- V: vertical direction
- α: angle between both levers

## Claims

1. Module assembly (11) for a plug-in module (5) or a connector (3), the assembly (11) comprising at least one combined driving and locking mechanism (19) with a first lever (27) and a second lever (29), each lever (27, 29) being supported rotatably around a rotary axis (31, 33), the rotary axes (31, 33) of the levers (27, 29) being spaced apart from each other in a horizontal direction (H), wherein the module assembly (11) comprises a coupling arrangement (43) mechanically coupling the rotational movements of the two levers (27, 29) with each other, wherein each lever (27, 29) is provided with at least one driving member (59, 61) which is rotatable with its corresponding lever (27, 29) around the lever's rotary axis (31, 33), and wherein the combined driving and locking mechanism (19) is movable between an insertion position (23) and a locking position (25), wherein an angle (α) between both levers (27, 29) is smaller in the insertion position (23) than in the locking position (25) and wherein the levers (27, 29) are latched with each other in the locking position (25).

2. Module assembly (11) according to claim 1, **characterized in that** the at least one coupling arrangement (43) is provided with at least one cam track (47) on at least one of the levers (27, 29) and at least one pin (45) on the other lever (27, 29), wherein the at least one pin (45) is slidable arranged in the at least one cam track (47).

3. Module assembly (11) according to claim 1 or 2, **characterized in that** the first lever (27) is provided with at least one latching member (83) and the second lever (29) is provided with at least one complementary latching member (107), the latching members (83, 107) being engaged with each other in the locking position (25).

4. Module assembly (11) according to claim 3, **characterized in that** the at least one latching member (83) is supported slidably on the first lever (27) along a longitudinal direction (75) of the lever (27), the longitudinal direction (75) of the lever (27) being perpendicular to the rotary axis (31) of the lever (27).

5. Module assembly (11) according to claim 4, **characterized in that** the first lever (27) comprises at least one actuating part (89) and at least one supporting part (91), wherein the at least one supporting part (91) is supported rotatably around the first lever (27)'s rotary axis (31), and wherein the at least one actuating part (89) is provided with the at least one latching member (83) and is held slidably on the at least one supporting part (91) perpendicular to the rotary axis (31) of the first lever (27).

6. Module assembly (11) according to claim 5, **characterized in that** a spring (97) is provided between the at least one actuating part (89) and the at least one supporting part (91), the spring (97) urging apart the at least one actuating part (89) and the at least one supporting part (91) in a direction perpendicular to the rotary axis (31) of the first lever (27)

7. Module assembly (11) according to any of claims 2 to 6, **characterized in that** the at least one cam track (47) is adapted for allowing a translational movement of the levers (27, 29) relative to each other along the horizontal direction (H), at least in the locking position (25).

8. Module assembly (11) according to any of claims 4 to 7, **characterized in that** the second lever (29) is provided with at least one secondary locking means (111) which, in a blocking position (113) of the secondary locking means (111), blocks the disengagement of the levers (27, 29) from each other.

9. Module assembly (11) according to claim 8, **characterized in that** the at least one secondary locking means (111) is seated on a leaf spring (123), wherein the secondary locking means (111) is arranged in the blocking position (113) when the leaf spring (123) is in a resting position (124).

10. Module assembly (11) according to claim 9, **characterized in that** the at least one secondary locking means (111) is arranged on a free end (121) of the leaf spring (123), wherein, in the blocking position (113), the at least one secondary locking means (111) is arranged between an abutment portion (115) of the actuating part (89) of the first lever (27) and a counter abutment portion (117) of the second lever (29), blocking the movement of the actuating part (89) perpendicular to the rotational axis (31) of the first lever (27).

11. Module assembly (11) according to any of claims 8 to 10, **characterized in that** the first lever (27) is provided with at least one release member (129) with which the at least one secondary locking means (111) is movable from the blocking position (113) into a releasing position.

12. Module assembly (11) according to claim 11, **characterized in that** the at least one release member (129) is formed as a pushing portion (131) of the actuating part (89) which is elastically deflectable towards the at least one secondary locking means (111) in the locking position (25).

13. Module assembly (11) according to any of claims 5 to 12, **characterized in that** the at least one actuating part (89) is provided with at least one insertion channel (143) and the at least one supporting part (91) is provided with at least one through hole (137), wherein the at least one insertion channel (143) and the at least one through hole (137) are aligned with each other parallel to the rotary axis (31) of the first lever (27) at least when the levers (27, 29) are latched with each other.

14. Module assembly (11) according to any of claims 1 to 13, **characterized in that** the at least two driving members (59, 61) are shaped such that insertion faces (63, 65) of the driving members (59, 61) are aligned parallel with an insertion direction (I) of the module assembly (11) in the insertion position (23).

15. Connector system (1) comprising a connector (3) with at least one module assembly (11) according to any of claims 1 to 14 and at least mating connector (7) for being connected to the connector (3), the mating connector (7) comprising at least two engagement members (81) for engaging the at least two driving members (59, 61) of the at least one module assembly (11).
